# EUROPEAN PATENT SPECIFICATION

(11) **EP 1 696 529 B1**
(45) Date of publication and mention of the grant of the patent: **15.10.2008**
(21) Application number: 05300153.3
(22) Date of filing: 28.02.2005
(51) Int. Cl.: H01S 5/40, H01S 3/23

(54) **Device for wide range continuous wavelength sweeping on a set of tunable laser sources**
Vorrichtung zur kontinuierlichen Variation der Wellenlänge über einen weiten Bereich mit einem Satz abstimmbarer Laserlichtquellen
Appareil source à laser accordable avec fonction de balayage continue et à large bande de longueur d'onde d'oscillation

(43) Date of publication of application: 30.08.2006
(73) Proprietor: Anritsu Instruments SAS, 91140 Villebon Sur Yvette (FR)
(72) Inventor: DUCLOUX, Eric, 92210, SAINT CLOUD (FR)
(74) Representative: Michelet, Alain

(56) References cited:
- WO-A-03/015226
- US-A- 4 817 101
- US-A1- 2002 090 011
- US-B1- 6 275 317

## Description

The invention is a device used to drive a set of tunable laser sources emitting an output laser signal sweepable over a global wavelength range. It provides a tunable laser source which may have a very large tuning range. It may be used with test and measurement instruments for optical communications or with sensor applications or optical spectrum analysis.

Many available tunable lasers may sweep continuously on a range between few nm to 200nm and can address the wavelength of the output beam with an accuracy between few pm and few nm. None of them can individually sweep on more than 200nm.

To overcome the bandwidth limitation, the connection between 2 or more tunable lasers is usually done through software driver, using the precision of each instrument to address the wavelengths. This cannot guarantee the perfect covering of all wavelengths, as it is dependant on the wavelength estimation of each instrument. Furthermore, it cannot provide identical wavelength accuracy on the global range if a heterogeneous set of sources is used and especially if one instrument does not have wavelength information by itself.

Document WO-03/015226A2 discloses a "method and system for selecting an output of a VCSEL array" using a movable optical element. Sweeping of VCSEL is also described as to obtain in the system a wide range continuous wavelength sweeping by switching VCSEL outputs.

The invention as defined in claim 1 is about a device for wide range continuous wavelength sweeping on a set of tunable laser sources over a predetermined global wavelength range, said device working with at least one functional pair of cooperating tunable lasers, each laser of the cooperating pair emitting over a sub range of the global wavelength range, the sub ranges of a functional pair partly overlapping each other in an overlapping wavelength zone, all the sub ranges being comprised within the global wavelength range and the sweeping of said output laser signal being done by the selection and tuning of one of the lasers of one of the functional pairs at a time.

According to the invention, the device comprises for a functional pair of cooperating tunable lasers an optical switch and an heterodyne optical detector, the optical switch allowing the selection as output laser signal of one of the two laser signals of the pair, the heterodyne optical detector receiving an optical combination of (part of) the two laser signals of the pair and producing a control signal, the control signal being a binary signal for toggling (directly or not) the optical switch when the two laser signals of the pair are found to have sensibly the same wavelength, before toggling the non-selected laser of the pair being at a fixed wavelength within the overlapping wavelength zone of the pair.

The core of the invention is then a device comprising an optical switch and an heterodyne optical detector with means for controlling at least the optical switch (and at least for starting sweeping of each laser sources when required). It may be provided to users alone, the users using their own laser sources or it may be provided to users including the laser sources. The pairs are functionally defined in that a pair is made of two lasers which have overlapping wavelength tuning ranges, that means that the device is made of at least two lasers (one pair), it can be made of three lasers (two pairs), it can be made of four lasers (three pairs), it can be made of five lasers (four pairs) and so on, as to have the predetermined wavelength range made from selection within those partly overlapping sub ranges. In case more than two lasers are used in the device, the selected functional pair depends of the direction of the sweep/scan (toward higher wavelength or the reverse) as the non-selected laser of the pair should be the one which allows to continue the sweep in the same direction after toggling.

Following means, individually or in any technically possible combination, are also contemplated within the invention:
- the heterodyne optical detector comprises a photo detector for measuring the combination of optical signals, an amplifier, a band-pass electronic filter for selecting electric signal from the photo detector in the radio-frequency range, a demodulator and an electronic trigger,
- the detector is sensitive to the difference of the two wavelengths and toggling occurs when the difference is lower than a predefined value and captured within the RF filter function, (the predefined value of the difference is usually far below the required wavelength precision)
- the band-pass filter has a corner frequency around 70MHz,
- in case an increased precision is needed, (during the sweeping) the toggling is delayed after the difference is captured within the RF filter function and according to a correction function estimating the moment the difference will be null, (due to the bandwidth of the filter, the capture occurs when the two wavelength are not completely equal but sensibly equal, as the sweep of the selected laser is continuing, delaying the toggling can result in the toggling being done when the two wavelength are equal)
- the photo detector is a photodiode,
- the toggling is latched, directly or through remote control, when the laser signals are found to have sensibly the same wavelength,
- the toggling is latched, directly or through remote control, after the laser signals are found to have sensibly the same wavelength,
- the toggling is latched, directly or through remote control, when the laser signals are estimated to have the same wavelength,
- the latch is released through remote control for a new sweep,
- the device comprises a 2x2 optical switch with two inputs and two outputs, each of the lasers of a pair being feed to a respecting input of the optical switch, a first output of the switch being feed to the output of the device, the second output of the optical switch being combined to a part of the signal from the first output through an optical coupler, the combined signal being feed to the entry of the heterodyne optical detector,
- the device works with one functional pair of lasers and comprises a 2x2 optical switch with two inputs and two outputs, each of the lasers being feed to a respecting input of the optical switch, a first output of the switch being feed to the output of the device, the second output of the optical switch being combined to a part of the signal from the first output through an optical coupler, the combined signal being feed to the entry of the heterodyne optical detector,
- the device works with more than two tunable laser sources and the optical configuration is constructed by a cascaded set of devices with the number of devices which equals the number of tunable laser sources minus one,
- the device works with more than two tunable laser sources and the optical configuration is constructed by a cascaded set of 2x2 optical couplers with one heterodyne optical detector receiving the combined signals from each optical coupler and with a number of optical couplers which equals the number of tunable laser sources minus one,
- a wavelength monitoring system taking advantage of the continuous wavelength sweeping on the global range is measuring the wavelength value of the device output laser signal,
- at least one of the lasers is replaced by a cluster of at least two tunable lasers and an optical multiplexer system for selecting one of the laser of the cluster and the device has means for choosing as the non-selected laser, the laser of the cluster which has the closest sweepable range from the device output laser signal wavelength, each laser being placed in the cluster(s) according to its sub range as for the device to have a continuously tunable output, a functional pair of lasers being not in the same cluster,
- the signals are feed by optical fibers within the device and within the possible optical configurations,
- the part of signal feed to the heterodyne optical detector is obtained with an optical fiber coupler,
- the part of the signal obtained with an optical fiber coupler is sufficient to allow the heterodyne detection,
- the part of the signal obtained with an optical fiber coupler is lower than 10%,
- the part of the signal obtained with an optical fiber coupler is approximately 5%.

Thus, the present invention is dedicated to the perfect switching between sweeping tunable lasers sources (TLS) of any kind (instrument, component or OEM) in order to sweep on a global wavelength range given by the use of successive individual laser sub ranges, leaving the opportunity to measure the wavelength during the sweep through interferometric or any other method with the same precision throughout the global range, independently of the TLS operating at each position. Thanks to the invention, it is possible with a set of N tunable laser sources (TLS) having wavelength overlap areas two by two, to make the connection between these TLS without any blank in the global wavelength coverage, whatever the wavelength accuracy of each instrument is and even if one or more of the TLS does not provide any wavelength information by itself. It is also possible to use any kind of TLS having the ability to make a continuous wavelength sweep on all its accessible range, whatever its scan speed is and even if the only accessible command are the start and stop of the sweep, without any need to query of any information such as the wavelength, the scan speed, the output power or other characteristics of the TLS.

It has to be recalled that for most of sweeping TLS there is usually no possibility of direct wavelength access and when a sweep is initiated, it goes on its own. As the wavelength when switching occurs is perfectly defined as being the moment when the wavelength of a functional pair are sensibly equal, the device having the wavelength monitoring system is able to have a continuous information on output wavelength all over the global wavelength range even after switching and even if the wavelength at the switching point (toggling) is not known by itself, the wavelength of the newly selected laser being defined by reference to the first one selected in the global range. When toggling occurs, the device stops the wavelength referencing (measure) and memorize the current wavelength which is thus the one of the TLS which was waiting at the overlapping zone before toggling as toggling occurs when the two wavelength are sensibly equal. The wavelength referencing then restart with the newly selected laser starting from the memorized wavelength and all along its sweep. Thus all wavelength referencing can be done using a single reference preferably at the starting wavelength of the first selected laser of the global range.

The invention uses a simple heterodyne detection which is highly sensitive for selected and connected pair of wavelength adjacent TLS (called a functional pair) without any blank in the wavelength sweep and without constraint on the scan speed. It is understood that if the TLS have a possibility of wavelength direct access or more parameters controls, the way the device can be exploited may be extended.

Non-limiting examples of the invention will now described in relation to the following Figures:
Figure 1 showing the global bandwidth sweep available with N successive tunable lasers sources connected by heterodyne switch and forming pairs of functional lasers,
Figure 2 showing means for the switching between a pair of two tunable lasers with the device of the invention in a preferred embodiment,
Figure 3 showing means for the switching between three TLS which can be configured as two pairs of functional lasers and using two devices of the invention in a preferred embodiment,
Figure 4 showing means for the switching between four TLS which can be configured as three pairs of functional lasers and using three devices of the invention in a preferred embodiment,
Figure 5 showing means for the switching between four TLS which can be configured as three pairs of functional lasers and using heterodyne detection in an alternative mode of realization.

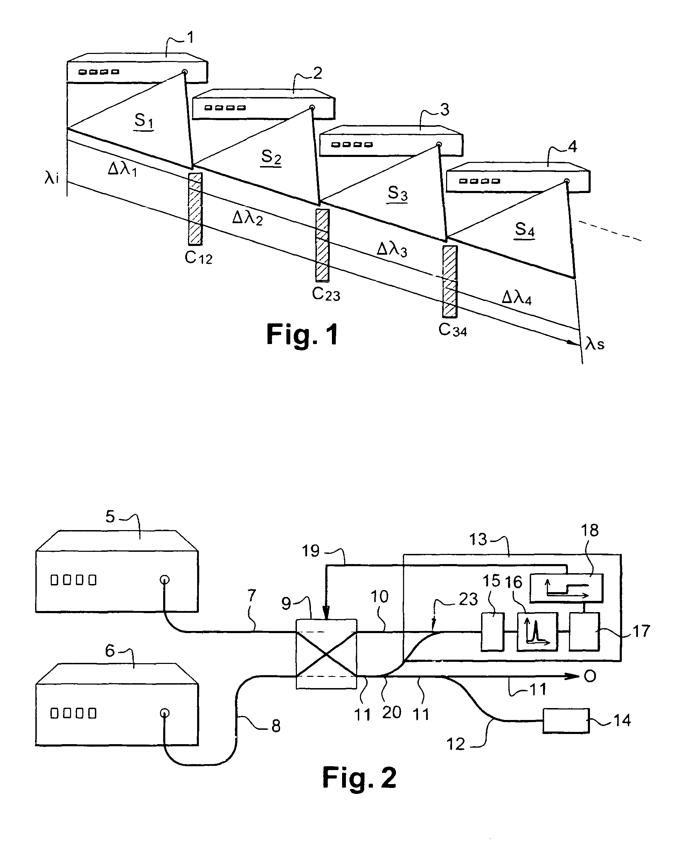

For the device of the invention to be operative, each TLS should be able to sweep continuously on its specific range Δλᵢ, and should have a common, overlapping, whatever its size, area of wavelength with another TLS on both sides of its bandwidth range (except for TLS used at the extremities of the global range). Such a structure is schematized on Figure 1, where four laser sources are represented as boxes numbered 1, 2, 3 and 4. Each laser source is tunable and sweepable over its specific wavelength sub range, Δλ₁ for laser 1, Δλ₂ for laser 2, Δλ₃ for laser 3, Δλ₄ for laser 4 in the order or sub ranges, for example laser 1 having the lowest wavelength sub range. Those wavelength sub ranges are represented in the wavelength domain as spectra S1, S2, S3, S4 respectively. Those sub ranges or spectra are overlapping (except for the lowest λᵢ and the highest λₛ possible wavelengths) two by two in overlapping ranges of functional pairs of lasers: C12 for the overlapping range between functional pair of lasers 1 and 2 (spectra S1 and S2), C23 for the overlapping range between functional pair of lasers 2 and 3 (spectra S2 and S3), C34 for the overlapping range between functional pair of lasers 3 and 4 (spectra S3 and S4). It is obvious that the sub range of a first laser of a functional pair should not be totally comprised in the other one's sub range as there would be no benefit of a global range extending beyond sub range of each laser.

On Figure 1, within each overlapping range represented as gray area, the wavelength were the device switches from one laser source to the other one of the corresponding functional pair is represented as a vertical line between the sub ranges. It should be understood that such a structure can be increased in the number of laser sources and that the number of functional pairs of lasers is equal to the number of lasers minus one.

The computing means used to manage the device has not been represented for simplification reasons but the operation of the device is under such a supervision, notably when multiple functional pairs or clusters of TLS are used, for the selection of a current (the functional pair currently used for producing laser output signal of the device) functional pair of TLS. The choice of a current functional pair and/or the resting wavelength of the non selected TLS is dependent of the direction of the sweep. Preferably the computing means use a DSP.

During sweeping operation toward the higher wavelength λₛ of the device, each TLS which is selected starts from its lower position for a sweep toward higher wavelengths of its sub range till a new TLS is selected for the next sub range or the end λₛ of the global range reached. In the reverse direction, toward lower wavelength of the global range, each TLS is sweep from its higher position toward the lower wavelength of its sub range.

Figure 2 is a preferred embodiment of the device of the invention where two TLS 5 and 6 are used and whose laser signal outputs are feed through optical fibers 7 and 8 respectively to the two inputs of a 2x2 optical switch 9.

In the initial switch 9 configuration, signal from TLS 5 is routed toward the user output O of the device through an optical fiber 11 and signal from TLS 2 is routed through fiber 10 toward a first entry of an heterodyne detector 13. A small part of the user output signal, preferably around 5%, from fiber 11 is feed to the second entry of the heterodyne detector 13 by dint of an optical coupling device 20. In the heterodyne detector 13, an optical combination device 23 combines the signals from the two entries, that is from fiber 10 and from optical coupling device 20 to obtain the wavelength difference which is measured by a photo detector, preferably a photodiode 15. It can be noted that the optical combination device 23 may be physically outside or inside the heterodyne detector 13, in the first case, said heterodyne detector 13 having only one entry toward the photo detector. The combined signal enters the photodiode 15 and the measured electric signal, possibly amplified, is sent to a RF pass band filter 16. The filtered electric signal is then demodulated in a demodulator 17 which output is sent to an electronic trigger 18 which controls and toggle the optical switch 9 through a control line 19. The knowledge of the RF filter transfer function allows detecting the exact moment where both TLS are at the same wavelength.

The two TLS 5 (low sub range) and 6 (high sub range) are initially positioned on their lower respective wavelengths then TLS 5 is launched to sweep up on all its accessible range and when its wavelength reaches the wavelength of TLS 6 waiting position, the heterodyne detector triggers/toggle the optical switch, routing the TLS 6 toward the user output O and the TLS 6 is then launched to complete the scan. It should be noted that in case of bi-directional sweeping possibilities, means for setting (to set the wavelengths of the TLS on their highest point of switching of their sub range or end of range for the TLS at end of global range) or resetting (to reset the wavelength of the TLS on their lowest point of switching of their sub range or end of range for the TLS at end of global range) are used to be able to restart a sweep from any wavelength. It is also possible to program starting and/or ending wavelength point for sweeping and thus, set and reset operations could be done on part or all of the functional pairs.

Only one wavelength may be known, like the starting wavelength λ₀ of TLS 5. All wavelengths during the sweep could then be known by reference of it using interferometric or any other wavelength monitoring 14 system (counting of fringes for example), receiving part of the output signal by an optical fiber 12, and available as the sweep is continuous from its starting position. Apart from λ₀, no requirement on the wavelength accuracy has to be made for any TLS to get the wavelength value during the scan.

One can note that as the heterodyne detector 13 provides a measurement in relation to the difference of wavelength between the output signal of the device and another optical signal, it can be used to provide information on the output wavelength if the another signal can be known, for example a reference laser signal used for that purpose (this is on the non-selected signal and thus do not interfere with output, the computing means re-establishing the initial TLS when no measurement needed or when a switching between TLS of the pair is probable). Using such reference laser signal may be useful for increasing the precision of a calibration process of the sweeping of TLS. Alternatively, if the wavelength of the reference laser signal is in fact not known and the device is used to determine it, the device with sweeping and wavelength referencing by dint of the wavelength monitoring 14 system can be used to determine when the two wavelength are sensibly equal (the sweeping which is wavelength referenced and the unknown reference laser).

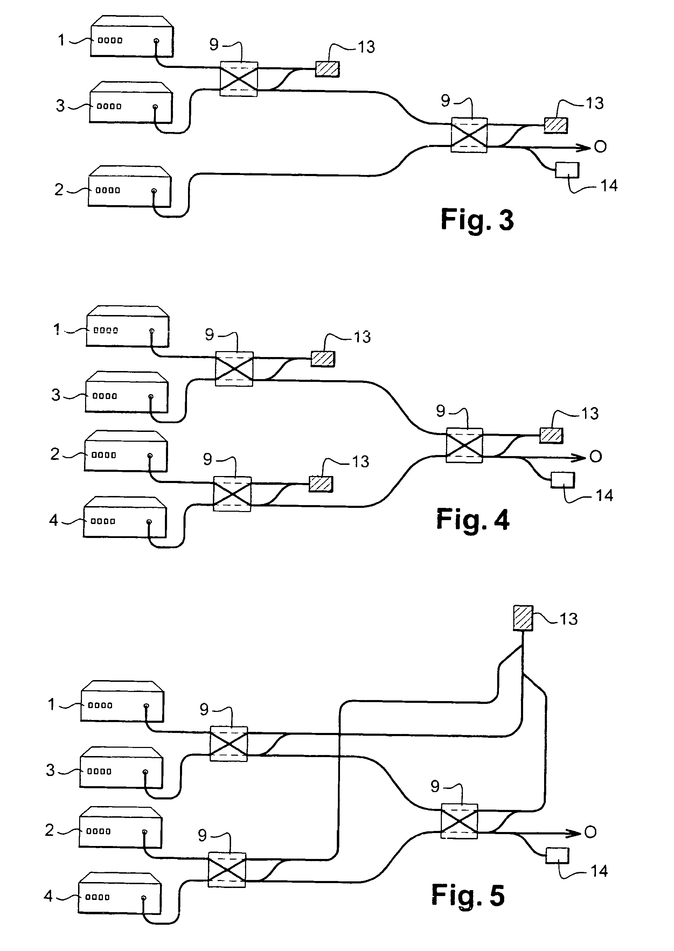

Other implementations of the device of the invention allowing the use of more than two TLS are now described in relation to Figures 3 and 4 cascading the device of the invention and Figure 5 which is an equivalent implementation of the one of Figure 4.

On Figure 3, three TLS are connected to two cascaded devices having each an optical switch 9 and an heterodyne optical detector 13. The TLS are connected as to allow all possible functional pairs to be selected by the two cascaded devices of the invention. On Figure 4, four TLS are connected to three cascaded devices having each an optical switch 9 and an heterodyne optical detector 13. The TLS are connected as to allow all possible functional pairs to be selected by the three cascaded devices of the invention. Other implementations for greater number of TLS can be deduced by way of equivalence from those examples by cascading the devices.

In the previous examples, a number of heterodyne detector equal to the number of TLS minus one is used. It is possible to reduce this number by feeding all the combined signals from all optical switch to a unique heterodyne optical detector as this has been represented on Figure 5 which is equivalent to Figure 4 with its four TLS. In such implementation it is preferable that the TLS which are not part of the currently used functional pair of TLS be switched off.

In a variation of previous implementations, notably starting from the implementation of Figure 2, the TLS 5 and 6 may be replaced by cluster(s) of laser sources which can be selected individually as to make functional pairs of lasers (two lasers with overlapping sub ranges) whose signals are feed to the optical switch 9. In such instance, for all possible functional pairs, the first laser of the pair should be feed to the first entry of the optical switch and the second laser of the pair should be feed to the second entry of the optical switch. For example combining Figures 1 and 2, laser 5 is a cluster 5 of two LTS and laser 6 is a cluster 6 of two other LTS, cluster 5 allows selection between lasers 1 and 3 and cluster 6 allows selection between lasers 2 and 4. This allows all possible functional pairs to be selected by the device of the invention.

Finally, it has to be noted that the device may accept a few discontinuities on the wavelength coverage of each individual TLS, at the expense of the wavelength referencing accuracy, if this incomplete coverage does not affect the area where the laser coupling (overlapping zone) occurs.

## Claims

1. Device for wide range continuous wavelength sweeping on a set of tunable laser sources over a predetermined global wavelength range, said device working with at least one functional pair (1,2) (2,3) (3,4) (5,6) of cooperating tunable lasers, each laser of the cooperating pair emitting over a sub range of the global wavelength range, the sub ranges of a functional pair partly overlapping each other in an overlapping wavelength zone, all the sub ranges being comprised within the global wavelength range and the sweeping of said output laser signal being done by the selection and tuning of one of the lasers of one of the functional pairs at a time, the device comprising for a functional pair of cooperating tunable lasers an optical switch (9), the optical switch allowing the selection as output laser signal of one of the two laser signals of the pair, **characterized in that** the device comprises at least one heterodyne optical detector (13), the heterodyne optical detector receiving an optical combination of the two laser signals of the pair and producing a control signal, the control signal being a binary signal for toggling the optical switch when the two laser signals of the pair are found to have the same wavelength, before toggling the non-selected laser of the pair being at a fixed wavelength within the overlapping wavelength zone of the pair.

2. Device according to claim 1, **characterized in that** the heterodyne optical detector comprises a photo detector for measuring the combination of optical signals, an amplifier, a band-pass electronic filter for selecting electric signal from the photo detector in the radio-frequency range, a demodulator and an electronic trigger.

3. Device according to claim 2, **characterized in that** the detector is sensitive to the difference of the two wavelengths and toggling occurs when the difference is lower than a predefined value and captured within the RF filter function.

4. Device according to claim 3, **characterized in that,** in case an increased precision is needed, the toggling is delayed after the difference is captured within the RF filter function and according to a correction function estimating the moment the difference will be null.

5. Device according to any one of previous claims, **characterized in that** it comprises a 2x2 optical switch with two inputs and two outputs, each of the lasers of a pair being feed to a respecting input of the optical switch, a first output of the switch being feed to the output of the device, the second output of the optical switch being combined to a part of the signal from the first output through an optical coupler, the combined signal being feed to the entry of the heterodyne optical detector.

6. Device according to claim 5, **characterized in that** it works with one functional pair (5,6) of lasers and comprises a 2x2 optical switch (9) with two inputs and two outputs, each of the lasers being feed to a respecting input of the optical switch, a first output of the switch being feed to the output of the device, the second output of the optical switch being combined to a part of the signal from the first output through an optical coupler, the combined signal being feed to the entry of the heterodyne optical detector.

7. Device according to claim 5, **characterized in that** it works with more than two tunable laser sources and the optical configuration is constructed by a cascaded set of devices with the number of devices which equals the number of tunable laser sources minus one.

8. Device according to claim 5, **characterized in that** it works with more than two tunable laser sources and the optical configuration is constructed by a cascaded set of 2x2 optical couplers with one heterodyne optical detector receiv ing the combined signals from each optical coupler and with a number of optical couplers which equals the number of tunable laser sources minus one.

9. Device according to any one of previous claims, **characterized in that** a wavelength monitoring (14) system taking advantage of the continuous wavelength sweeping on the global range is measuring the wavelength value of the device output laser signal.

10. Device according to any one of the previous claims, **characterized in that** at least one of the lasers is replaced by a cluster of at least two tunable lasers and an optical multiplexer system for choosing one of the laser of the cluster and that it has means for selecting as the non-selected laser, the laser of the cluster which has the closest sweepable range from the device output laser signal wavelength, each laser being placed in the cluster(s) according to its sub range as for the device to have a continuously tunable output, a functional pair of lasers being not in the same cluster.

## Patentansprüche

1. Vorrichtung zur kontinuierlichen Variation der Wellenlänge über einen vorgegebenen weiten Bereich mit einem Satz abstimmbarer Laserlichtquellen, wobei die Vorrichtung mit wenigstens einem funktionellen Paar (1,2), (2,3), (3,4), (5,6) zusammenwirkender abstimmbarer Laser betrieben wird, wobei jeder Laser des zusammenwirkenden Paars über einen Unterbereich des weiten Wellenlängenbereichs emittiert, die Unterbereiche eines funktionellen Paars sich in einer Überlappungswellenlängen-Zone jeweils teilweise gegenseitig überlappen, alle Unterbereiche innerhalb des weiten Wellenlängenbereichs eingeschlossen sind und die Variation des Ausgangslasersignals jeweils durch Auswahl und Abstimmung eines der Laser eines der funktionellen Paare erfolgt, wobei die Vorrichtung für ein funktionelles Paar zusammenwirkender abstimmbarer Laser einen optischen Schalter (9) umfasst, wobei der optische Schalter die Auswahl eines der zwei Lasersignale des Paars als Ausgangslasersignal gestattet,
**dadurch gekennzeichnet,**
**dass** die Vorrichtung wenigstens einen optischen Überlagerungsdetektor (13) umfasst, wobei der optische Überlagerungsdetektor eine optische Kombination der zwei Lasersignale des Paars empfängt und ein Steuersignal erzeugt, das ein binäres Signal zur Umschaltung des optischen Schalters ist, wenn die beiden Lasersignale des Paars mit gleicher Wellenlänge ermittelt wurden, bevor der nicht-gewählte Laser des Paars, der auf einer festen Wellenlänge innerhalb der Überlappungswellenlängen-Zone des Paars liegt, umgeschaltet wird.

2. Vorrichtung nach Anspruch 1,
**dadurch gekennzeichnet,**
**dass** der optische Überlagerungsdetektor einen Photodetektor zur Messung der Kombination der optischen Signale, einen Verstärker, ein elektronisches Bandpassfilter zur Auswahl des elektrischen Signals von dem Photodetektor im Hochfrequenzbereich, einen Demodulator und einen elektronischen Trigger umfasst.

3. Vorrichtung nach Anspruch 2,
**dadurch gekennzeichnet,**
**dass** der Detektor auf die Differenz der beiden Wellenlängen anspricht und die Umschaltung erfolgt, wenn die Differenz geringer als ein vorgegebener Wert ist und innerhalb der HF-Filterfunktion eingefangen ist.

4. Vorrichtung nach Anspruch 3,
**dadurch gekennzeichnet,**
**dass** bei geforderter größerer Präzision die Umschaltung verzögert wird, bis die Differenz innerhalb der HF-Filterfunktion eingefangen ist, und gemäß einer Korrekturfunktion, die den Moment abschätzt, in dem die Differenz Null sein wird.

5. Vorrichtung nach einem der vorausgehenden Ansprüche,
**dadurch gekennzeichnet,**
**dass** sie einen optischen 2x2-Schalter mit zwei Eingängen und zwei Ausgängen umfasst, wobei jeder der Laser eines Paars zu einem diesbezüglichen Eingang des optischen Schalters geführt wird, ein erster Ausgang des Schalters an den Ausgang des Geräts geführt wird, der zweite Ausgang des optischen Schalters durch einen optischen Koppler mit einem Teil des Signals von dem ersten Ausgang kombiniert wird und das kombinierte Signal zu dem Eingang des optischen Überlagerungsdetektors geführt wird.

6. Vorrichtung nach Anspruch 5,
**dadurch gekennzeichnet,**
**dass** sie mit einem funktionellen Paar (5,6) Lasern betrieben wird und einen optischen 2x2-Schalter (9) mit zwei Eingängen und zwei Ausgängen umfasst, wobei jeder der Laser einem diesbezüglichen Eingang des optischen Schalters zugeführt wird, ein erster Ausgang des Schalters dem Ausgang des Geräts zugeführt wird, der zweite Ausgang des optischen Schalters durch einen optischen Koppler mit einem Teil des Signals von dem ersten Ausgang kombiniert wird und das kombinierte Signal zum Eingang des optischen Überlagerungsdetektors geführt wird.

7. Vorrichtung nach Anspruch 5,
**dadurch gekennzeichnet,**
**dass** sie mit mehr als zwei abstimmbaren Laserquellen betrieben wird und die optische Konfiguration mit einem kaskadenartigen Satz von Vorrichtungen, deren Anzahl gleich der Anzahl der abstimmbaren Laserquellen minus eins ist, aufgebaut ist.

8. Vorrichtung nach Anspruch 5,
**dadurch gekennzeichnet,**
**dass** sie mit mehr als zwei abstimmbaren Laserquellen betrieben wird und die optische Konfiguration mit einem kaskadenartigen Satz von optischen 2x2-Kopplern mit einem optischen Überlagerungsdetektor, der die kombinierten Signale von jedem einzelnen optischen Koppler empfängt, und mit einer Anzahl optischer Koppler gleich der Anzahl der abstimmbaren Laserquellen minus eins aufgebaut ist.

9. Vorrichtung nach einem der vorausgehenden Ansprüche,
**dadurch gekennzeichnet,**
**dass** ein Wellenlängenüberwachungssystem (14), das sich auf die kontinuierliche Variation der Wellenlänge über den weiten Bereich stützt, den Wellenlängenwert des Ausgangslasersignals der Vorrichtung misst.

10. Vorrichtung nach einem der vorausgehenden Ansprüche,
**dadurch gekennzeichnet,**
**dass** wenigstens einer der Laser durch ein Cluster von wenigstens zwei abstimmbaren Lasern und einem optischen Multiplexer-System zum Auswählen eines der Laser des Clusters ersetzt ist, und dass sie Mittel zur Wahl als nicht gewählten Laser den Laser des Clusters, der den engsten überstreichbaren Bereich von der Ausgangslasersignalwellenlänge der Vorrichtung hat, aufweist, wobei jeder Laser in dem bzw. den Clustern entsprechend seinem Unterbereich angeordnet ist, damit die Vorrichtung einen kontinuierlich abstimmbaren Ausgang hat, ein funktionelles Laserpaar jedoch nicht in demselben Cluster angeordnet ist.

## Revendications

1. Dispositif pour un balayage de longueurs d'onde continu et à large bande sur un ensemble de sources laser accordables, sur une bande de longueurs d'ondes globale prédéterminée, ledit dispositif fonctionnant avec au moins une paire fonctionnelle (1, 2) (2, 3) (3, 4) (5, 6) de lasers accordables coopérants, chaque laser de la paire coopérante émettant sur une sous-bande de la bande de longueurs d'onde globale, les sous-bandes d'une paire fonctionnelle se chevauchant partiellement dans une région de longueurs d'onde en chevauchement, toutes les sous-bandes étant contenues dans la bande de longueurs d'onde globale et le balayage dudit signal laser de sortie étant effectué par sélection et accord successifs de l'un des lasers de l'une des paires fonctionnelles, le dispositif comprenant un commutateur optique (9) pour une paire fonctionnelle de lasers accordables coopérants, le commutateur optique permettant la sélection, en tant que signal laser de sortie, de l'un des deux signaux laser de la paire, **caractérisé en ce que** le dispositif comprend au moins un détecteur optique hétérodyne (13), le détecteur optique hétérodyne recevant une combinaison optique des deux signaux laser de la paire et produisant un signal de commande, le signal de commande étant un signal binaire servant à faire basculer le commutateur optique lorsqu'il est établi que les deux signaux laser de la paire ont la même longueur d'onde, avant le basculement, le laser non sélectionné de la paire ayant une longueur d'onde fixé contenue dans la région de longueurs d'onde en chevauchement de la paire.

2. Dispositif selon la revendication 1, **caractérisé en ce que** le détecteur optique hétérodyne comprend un photo-détecteur pour mesurer la combinaison de signaux optiques, un amplificateur, un filtre électronique passe-bande pour sélectionner un signal électronique en sortie du photo-détecteur dans la bande des radiofréquences, un démodulateur et un déclencheur électronique.

3. Dispositif selon la revendication 2, **caractérisé en ce que** le détecteur est sensible à la différence entre deux longueurs d'onde et il se produit un basculement lorsque la différence est inférieure à une valeur prédéfinie et capturée dans la fonction de filtre RF.

4. Dispositif selon la revendication 3, **caractérisé en ce que,** dans le cas où une plus grande précision est requise, le basculement est retardé après la capture de la différence dans la fonction de filtre RF et en fonction d'une fonction de correction estimant le moment où la différence sera nulle.

5. Dispositif selon l'une quelconque des revendications précédentes, **caractérisé en ce qu'**il comprend un commutateur optique 2 x 2 ayant deux entrées et deux sorties, chacun des lasers d'une paire étant acheminé jusqu'à une entrée respective du commutateur optique, une première sortie du commutateur étant acheminée jusqu'à la sortie du dispositif, la deuxième sortie du commutateur optique étant combinée à une partie du signal de la première sortie, par l'intermédiaire d'un coupleur optique, le signal combiné étant acheminé jusqu'à l'entrée du détecteur optique hétérodyne.

6. Dispositif selon la revendication 5, **caractérisé en ce qu'**il fonctionne avec une paire fonctionnelle (5, 6) de lasers et comprend un commutateur optique 2 x 2 (9) ayant deux entrées et deux sorties, chacun des lasers étant acheminé jusqu'à une entrée respective du commutateur optique, une première sortie du commutateur étant acheminée jusqu'à la sortie du dispositif, la deuxième sortie du commutateur optique étant combinée à une partie du signal provenant de la première sortie, par l'intermédiaire d'un coupleur optique, le signal combiné étant acheminé jusqu'à l'entrée du détecteur optique hétérodyne.

7. Dispositif selon la revendication 5, **caractérisé en ce qu'**il fonctionne avec plus de deux sources laser accordables et la configuration optique est construite par un ensemble de dispositifs en cascade, où le nombre de dispositifs est égal au nombre de sources laser accordables moins un.

8. Dispositif selon la revendication 5, **caractérisé en ce qu'**il fonctionne avec plus de deux sources laser accordables et la configuration optique est construite par un ensemble de coupleurs optiques 2 x 2 en cascade, avec un détecteur optique hétérodyne recevant les signaux combinés de chaque coupleur, et avec un nombre de coupleurs optiques égal au nombre de sources laser accordables moins un.

9. Dispositif selon l'une quelconque des revendications précédentes, **caractérisé en ce qu'**un système de surveillance de longueur d'onde (14) tirant avantage du balayage de longueurs d'onde continu sur la bande globale mesure la valeur de longueur d'onde du signal laser de sortie du dispositif.

10. Dispositifselon l'une quelconque des revendications précédentes, **caractérisé en ce qu'**au moins l'un des lasers est remplacé par un groupe d'au moins deux lasers accordables et un système multiplexeur optique pour choisir l'un des lasers du groupe et **en ce qu'**il contient des moyens pour sélectionner, en tant que laser non sélectionné, le laser du groupe qui a la bande balayable la plus proche de la longueur d'onde du signal laser de sortie du dispositif, chaque laser étant placé dans le ou les groupes en fonction de sa sous-bande de façon que le dispositif ait une sortie accordable en continu, les lasers d'une paire fonctionnelle n'étant pas situés dans le même groupe.
